# EUROPÄISCHE PATENTSCHRIFT

(11) **EP 3 839 683 B1**
(45) Veröffentlichungstag und Bekanntmachung des Hinweises auf die Patenterteilung: **06.11.2024**
(21) Anmeldenummer: 20213994.5
(22) Anmeldetag: 15.12.2020
(51) Int. Cl.: G05B 23/02

(54) **SYSTEM MIT SELBSTPRÜFFUNKTION UND VERFAHREN ZUM VERIFIZIEREN DER SELBSTPRÜFFUNKTION EINES SYSTEMS**
SYSTEM WITH SELF-TEST FUNCTION AND METHOD FOR VERIFYING THE SELF-TEST FUNCTION OF A SYSTEM
SYSTÈME À FONCTION D'AUTO-CONTRÔLE ET PROCÉDÉ DE VÉRIFICATION DE L'AUTO-CONTRÔLE D'UN SYSTÈME

(30) Priorität: 20.12.2019 DE 102019135553
(43) Veröffentlichungstag der Anmeldung: 23.06.2021
(73) Patentinhaber: Airbus Defence and Space GmbH, 82024 Taufkirchen (DE)
(72) Erfinder: Brenner, Thomas, 82024 Taufkirchen (DE)
(74) Vertreter: LKGLOBAL Lorenz & Kopf Patentanwalt Attorney at Law PartG mbB

(56) Entgegenhaltungen:
- DE-A1- 102006 008 539
- US-A1- 2005 243 484

## Beschreibung

### TECHNISCHES GEBIET

Die Erfindung betrifft ein System mit Selbstprüffunktion und Verfahren zum Verifizieren der Selbstprüffunktion eines Systems

### HINTERGRUND DER ERFINDUNG

Flugzeuge und andere Transportmittel oder Fahrzeuge weisen üblicherweise eine umfangreiche elektronische Ausstattung auf, die beispielsweise als austauschbare Einheiten (LRI, "Line Replaceable Item" oder LRU, "Line Replaceable Unit") ausgeführt sind. Es ist für den ordnungsgemäßen Betrieb des Flugzeugs sinnvoll, derartige Einheiten mit einer Selbstprüffunktion auszustatten, um eventuelle Fehlfunktionen zeitnah erkennen und beheben zu können. Vor dem Betrieb des Flugzeugs oder in regelmäßigen Abständen kann die Selbstprüffunktion, welche auch als BIT ("Built-in Test") bekannt ist, ausgeführt werden. Der Nachweis der Selbstprüffunktion wird üblicherweise nach der Realisierung der zu prüfenden Einheit unter Laborbedingungen geführt.

Die US 2005 / 243 484 A1 beschreibt einen elektrischen Leckschutzschalter zur Selbstprüfung. Der elektrische Leckschutzschalter zur Selbstprüfung umfasst Stromversorgungsleitungen zum Verbinden einer Stromquellenversorgung mit einer Last, einen Nullphasen-Stromtransformator, der auf den Stromversorgungsleitungen installiert ist und zum Erfassen einer Stromdifferenz zwischen den Stromversorgungsleitungen dient, eine Leckstrom-Erfassungseinheit, die mit dem Nullphasen-Stromtransformator verbunden ist, um zu erfassen, ob ein Leckstrom auftritt, um ein Erfassungssignal zu erzeugen, eine Ansteuerungseinheit, um die Stromversorgungsleitungen zu unterbrechen, wenn eine kritische Spannung oder eine Spannung, die höher als die kritische Spannung ist, bereitgestellt wird, und eine Selbsttesteinheit zum periodischen Induzieren des Leckstroms an den Stromversorgungsleitungen, um zu testen, ob die Leckstrom-Erfassungseinheit normal arbeitet, und zum Bereitstellen einer niedrigeren Spannung als die kritische Spannung an die Ansteuerungseinheit, um zu testen, ob die Ansteuerungseinheit in einem Selbsttestbetrieb normal arbeitet.

Die DE 10 2006 008 539 A1 beschreibt ein Verfahren und eine Schaltungsanordnung zur Simulation von Fehlerzuständen in einem Steuergerät sowie ein Computerprogramm und ein Computerprogrammprodukt. Hierbei werden ein Multiplexer und eine Fehlererzeugungsschaltung eingesetzt, wobei der Multiplexer in einer Relais-Technologie realisiert ist und die Fehlererzeugungsschaltung in einer Halbleiter-Technologie implementiert ist.

### ZUSAMMENFASSUNG DER ERFINDUNG

Es wäre theoretisch denkbar, dass auch eine solche Selbstprüffunktion durch unvorhersehbare Bedingungen eingeschränkt sein könnte. Die Aufgabe der Erfindung liegt nun darin, ein System mit einer Selbstprüffunktion vorzuschlagen, wobei die Selbstprüffunktion auch verifizierbar ist.

Die Aufgabe wird durch ein System mit Selbstprüffunktion mit den Merkmalen des unabhängigen Anspruchs 1 gelöst. Unabhängiger Anspruch 9 definiert ein entsprechendes Verfahren. Vorteilhafte Ausführungsformen und Weiterbildungen sind den Unteransprüchen und der nachfolgenden Beschreibung zu entnehmen.

Gemäß der Erfindung wird ein System mit Selbstprüffunktion gemäß Anspruch 1 vorgeschlagen.

Die Verifikationssteuereinheit kann weiterhin dazu ausgebildet sein, aus einem Vergleich Abweichungen von einem erwarteten Ergebnis zu bestimmen. Diese könnten auf eine Beeinträchtigung der Selbstprüfeinheit schließen.

Es können insbesondere mehrere Systemkomponenten vorliegen, die miteinander verbunden sind oder auf andere Art miteinander interagieren, um das System auszubilden. Das zu prüfende System kann beliebiger Natur sein und mechanische sowie elektronische Systemkomponenten aufweisen. Allerdings liegt ein Hauptaugenmerk auf der Selbstprüffunktion von elektronischen Systemkomponenten, wie weiter nachfolgend ausgeführt. In einer allgemeinen Ausführungsform erfolgt jedoch zunächst keine derartige Beschränkung.

Eine wesentliche Komponente ist die Fehlersimulationseinheit, welche selektiv einzelne, technische Funktionen individueller Systemkomponenten gezielt beschränken kann, sodass die betreffende Systemkomponente mit der jeweiligen technischen Funktion einen vorgesehenen Betriebsbereich verlässt. Dieses Ereignis sollte durch die Selbstprüfeinheit erkannt werden, um resultierend daraus ein entsprechendes Warnsignal zu generieren. Die Selbstprüfeinheit überwacht demnach relevante Betriebsparameter, die den jeweiligen, beeinträchtigten technischen Funktionen zuzuordnen sind. Es kann sich dabei um ein separates oder ein integriertes Bauteil, das mit der mindestens einen Systemkomponente gekoppelt ist, oder einen in das System integrierten Algorithmus handeln. Die Selbstprüfeinheit weist Informationen über das normale Betriebsverhalten bei nicht beeinträchtigten technischen Funktionen auf. Durch Vergleich eines sich in Reaktion auf die technische Beeinträchtigung ergebenden Betriebsparameters mit einer normalen Größe des betreffenden Betriebsparameter kann ein abweichendes Betriebsverhalten ermittelt werden, was zur Generierung eines Warnsignals führt.

Die Verifikationssteuereinheit ist indes dazu vorgesehen, die Warnsignale, welche von der Selbstprüfeinheit generiert werden, mit den zu erwartenden Warnsignalen zu vergleichen. Werden folglich technische Funktionen selektiv derart beeinträchtigt, dass ein Betriebsbereich verlassen wird und ein Warnsignal erzeugt werden müsste, kann die Verifikationssteuereinheit das Generieren des Warnsignals verifizieren. Wird dieses nicht generiert, liegt eine Fehlfunktion in der Selbstprüfeinheit vor.

Die Fehlersimulationseinheit, die Selbstprüfeinheit und die Verifikationssteuereinheit sind derart miteinander verknüpft, dass beispielsweise die Fehlersimulationseinheit mehrere unterschiedliche technische Funktionen nacheinander beeinträchtigt und die Verifikationssteuereinheit darüber informiert, dass eine solche Einschränkung vorliegt. Die Verifikationssteuereinheit ist folglich in der Lage, ein entsprechendes Warnsignal zu empfangen und zu analysieren. Das Empfangen kann direkt oder indirekt, beispielsweise über eine nachfolgend genannte Monitoreinheit, erfolgen. Es ist vorstellbar, dass die Verifikationssteuereinheit einzelne Warnsignale, Beeinträchtigungen technischer Funktionen und empfangene Warnsignale miteinander korrelieren kann, um anschließend eine daraus entstandene Zustandsmatrix zu speichern, nach außen zu übertragen oder anzuzeigen.

In diesem Zusammenhang könnte ein Warnsignal auch mehr als lediglich eine Warnung an sich umfassen. Tatsächlich könnte das Warnsignal Informationen über technische Einschränkungen umfassen, die eine Aussage darüber treffen lassen, welche technische Funktion eingeschränkt ist. Diese Informationen könnten ebenso von der Verifikationssteuereinheit untersucht werden, um eine Aussage darüber zu treffen, ob korrekte Warnsignale ausgegeben werden, die auch eindeutig der jeweiligen technischen Einschränkung zuzuordnen sind.

Insgesamt ist das erfindungsgemäße System aufgrund der verifizierbaren Selbstprüffunktion in der Selbstprüfeinheit sehr vorteilhaft. Durch die sehr einfache Möglichkeit, verschiedene Fehler zu simulieren, kann die Selbstprüfeinheit zuverlässig geprüft werden. Es bietet sich dabei an, sämtliche, in einer Spezifikation angegebenen technischen Funktionen überprüfbar zu machen. Hierdurch ergeben sich mehrere Vorteile:
Die Verifikation kann insbesondere den vollständigen Funktionsumfang des betreffenden Systems umfassen. Es wäre wirtschaftlich unproblematisch, beispielsweise die ohnehin in komplexen elektronischen Systemen hohe Anzahl an Transistoren zu erhöhen und dabei alle funktionalen BIT-("Built-In-Test") Anforderungen im Detail zu verifizieren. Dies erhöht das Vertrauen in sicherheitsrelevante Systeme.

Die Vertrauenswürdigkeit der Selbstprüffunktion kann gesteigert werden, je einfacher die Selbstprüffunktion ist. Umgekehrt könnte der Grad des Vertrauens einer Selbstprüffunktion mit der Zahl der Annahmen sinken, die diesem Nachweis zugrunde liegen, sowie der Anzahl der erforderlichen logischen Schlüsse. Das erfindungsgemäße System kann durch möglichst realitätsnahe Fehlersimulation das Vertrauen deutlich steigern.

Das erfindungsgemäße System könnte als "Fail Safe"-System geeignet sein. Ein Ausfall der operationellen Hardware kann durch die Selbstprüffunktion erkannt werden. Ein Ausfall der Selbstprüffunktion wird ebenso mithilfe der Fehlersimulationseinheit und der Verifikationssteuereinheit verifizierbar. Ein Ausfall oder eine fehlerhafte Aktivierung einer Fehlersimulation wird durch die Selbstprüffunktion erkannt. Die Fehlersimulation und die Selbstprüffunktion können sich damit gegenseitig überwachen. Das Prinzip der gegenseitigen Überwachung kommt hier zur Geltung.

Das erfindungsgemäße System ist weiterhin flexibel einsetzbar. Die Fehlersimulationen können über einen Prozessor gesteuert und überwacht werden, wie weiter nachfolgend erläutert. Dieses gibt die Möglichkeit, auch noch nachträglich, z.B. in der Betriebsphase des Systems, den Verifikationsprozess über eine in dem Prozessor ausgeführte Software zu modifizieren.

Außerdem ist das erfindungsgemäße System kostengünstig. Es wird deutlich kostengünstiger, da kein weiteres System für Verifikationszwecke geopfert werden muss. Die eigentlich Hardware könnte durch die Integration der Fehlersimulationseinheit, Selbstprüfeinheit und Verifikationssteuereinheit zu marginal höheren Kosten des einzelnen Systems führen.

Das Beeinträchtigen einer technischen Funktion ist dahingehend zu verstehen, dass eine vorgesehene Funktion von der Systemkomponente nicht wie erwartet erfüllt wird. Zu diesem Zweck könnte etwa ein Bestandteil der betreffenden Systemkomponente gestört werden, indem falsche Eingangsgrößen angelegt werden, eine Logikschaltung unterbrochen oder gestört wird oder eine Ausgangsgröße verändert wird, beispielsweise durch Ändern elektrischer Größen, oder ähnliche Maßnahmen.

Grundsätzlich können an das erfindungsgemäße System mehrere Anforderungen gestellt werden, wie die vorangehend genannten Einheiten zusammenwirken, um eine Verifikation der Selbstprüffunktion zu erzielen. Das selektive Beeinträchtigen einer technischen Funktion durch die Fehlersimulationseinheit sollte etwa so realistisch wie möglich sein. Mehrere realistische Beeinträchtigungen, die im Laufe des Betriebs eines Systems auch tatsächlich auftreten könnten, sollten daher durch die Fehlersimulationseinheit realistisch umgesetzt werden können. Diese sollten weiterhin auch unter realen Betriebsbedingungen umsetzbar sein, wie weiter nachfolgend im Zusammenhang einer Stimulationseinheit noch deutlicher wird. Eine systematische Integration von Beeinträchtigungen technischer Funktionen, die dazu geeignet sind, eine vollständige Selbstprüfung des Systems durchzuführen, ist ferner sinnvoll.

Die Fehlersimulationseinheit sollte weiterhin derart umgesetzt werden, dass keine Nebeneffekte auftreten, die über die vorgesehene Beeinträchtigung einer technischen Funktion hinausgehen. Sie ist folglich zielgerichtet und - mit anderen Worten - bevorzugt dazu eingerichtet, insbesondere nacheinander verschiedene Beeinträchtigungen umzusetzen. Bei deaktivierter Fehlersimulationseinheit sollte weiterhin keinerlei Beeinträchtigung für das System vorliegen. Dies kann durch eine weiter nachfolgend beschriebene Isoliereinheit ergänzt werden. Die Fehlersimulationseinheit ist insbesondere dazu ausgebildet, bei realem Betrieb des Systems dauerhaft deaktiviert zu sein.

Erfindungsgemäß ist die mindestens eine Systemkomponente als elektrische oder elektronische Systemkomponente ausgeführt. Diese können unterschiedliche Arten von Systemkomponenten umfassen, die jeweils elektrisch mit anderen Systemkomponenten oder anderen Systemen verbunden sind und auf eine vorgegebene Weise mit diesen interagieren. Neben einfacheren elektrischen Systemkomponenten wie etwa Widerständen oder elektrischen Leitungen können auch einfache elektronische Systemkomponenten, wie Induktivitäten, Kapazitäten, Transistorschaltungen, Gleichrichter, Verstärkerschaltungen und ähnliches gemeint sein. Es sind allerdings auch komplexere integrierte Schaltkreise denkbar, die von Mikrocontrollern bis hin zu komplexen Prozessoren reichen könnten oder Schaltkreise mit darin integrierten Mikrocontrollern und Prozessoren. Elektrische oder elektronische Systemkomponenten, die von der Selbstprüfeinheit zu prüfen sind, können jeweils selektiv beeinflussbar sein, um einzelne elektrische Verbindungen selektiv zu unterbrechen oder üblicherweise nicht vorgesehene elektrische Verbindungen herzustellen.

In einer bevorzugten Ausführungsform weist die mindestens eine Systemkomponente eine Digitalelektronik auf. Eine Digitalelektronik kann insbesondere in Form einer komplexen integrierten Schaltung und insbesondere als eine Prozessoreinheit oder eine Recheneinheit ausgeführt sein. Eine Digitalelektronik basiert auf einer logischen Schaltung mit binären Zustandsmustern oder -folgen. Die Fehlersimulationseinheit kann in diesem Fall dazu ausgebildet sein, einzelne Abschnitte der Digitalelektronik so zu beeinflussen, dass Zustandsmuster oder - folgen binärer Signale verändert werden. Unter anderem kann dies durch das Beeinflussen von Logikgattern, das Beeinflussen eines elektrischen Ausgangs von Logikgattern oder durch andere Maßnahmen erreicht werden. Es können zur Umsetzung der Fehlersimulationseinheit zusätzliche Komponenten in das System integriert werden, insbesondere Transistoren. Die Anzahl der Transistoren einer Prozessoreinheit oder Recheneinheit wird dadurch lediglich marginal erhöht. Die zusätzlichen Komponenten dienen der selektiven, gesteuerten Beeinträchtigung insbesondere von Signalflüssen oder der Versorgung angrenzender Komponenten.

Erfindungsgemäß weist die Fehlersimulationseinheit mindestens eine elektronisch ansteuerbare Fehlersimulationszelle auf, die jeweils in der mindestens einen Systemkomponente integriert ist und dazu ausgebildet ist, selektiv eine Leitung der betreffenden Systemkomponente selektiv zu öffnen oder eine Verbindung der betreffenden Leitung mit einer anderen Leitung oder einer zusätzlichen Elektronikkomponente selektiv zu schließen. Das tatsächliche, selektive Öffnen einer Leitung kann dazu genutzt werden, eine Signalleitung, eine Stromleitung oder ähnliches zu unterbrechen, sodass die Selbstprüfeinheit durch Feststellen eines fehlenden Signals oder einer anderen Beeinträchtigung reagieren kann. Des Weiteren könnte durch eine Fehlersimulationszelle auch eine Verbindung hergestellt werden, die üblicherweise nicht vorgesehen ist. So könnte etwa damit eine Überbrückung zweier benachbarter Anschlüsse eines integrierten Schaltkreises oder Ähnliches simuliert werden. In einem einfachen Fall weist die Fehlersimulationszelle einen elektrischen Schalter auf. Dieser könnte in einer bevorzugten Ausführungsform als elektronischer Schalter, insbesondere auf Basis eines UND-Gatters, ausgeführt sein. Komplexe Systeme können eine ganze Reihe von Fehlersimulationszellen aufweisen, die mehrere technische Funktionen selektiv beeinträchtigen können, um eine komplexe Selbstprüffunktion zu realisieren.

Beispielhaft kann die andere Leitung eine Masseleitung oder eine Verbindung zum Logiklevel "1" aufweisen. Das Erkennen einer Verbindung einer Leitung der Systemkomponente mit einer Masseleitung könnte beispielsweise auf eine unzureichende elektrische Isolierung hindeuten, was von einem mechanischen Fehler ausgehen könnte.

Weiterhin könnte bei einer vorteilhaften Ausführungsform die zusätzliche Elektronikkomponente aus einer Gruppe von Elektronikkomponenten ausgewählt sein, die Gruppe aufweisend einen Widerstand, eine Kapazität, eine Induktivität, analoge Filter, digitale Filter, Logikbausteine, Überbrückungsleitungen, Spannungsquellen oder Mischformen hiervon. Durch derartige Elektronickomponenten können insbesondere elektrische Verbindungen unterbrochen, eingeschränkt, oder verändert werden. Damit können Signalstörungen simuliert werden, die beispielsweise einen repräsentativen, denkbaren Fehler betreffen.

In einer besonders vorteilhaften Ausführungsform weist die Fehlersimulationseinheit eine externe Steuereinheit und eine mit der externen Steuereinheit verbindbare interne Steuereinheit auf, wobei die mindestens eine Fehlersimulationszelle in der internen Steuereinheit angeordnet und von der externen Steuereinheit steuerbar sind, und wobei die mindestens eine Fehlersimulationszelle und/oder die interne Steuereinheit dazu ausgebildet sind, dass die mindestens eine Fehlersimulationszelle ohne Verbindung mit der externen Steuereinheit nicht geschaltet ist. Die Unterteilung in eine externe Steuereinheit und eine interne Steuereinheit ist bei Realisierung einer größeren Anzahl von Fehlersimulationszellen besonders sinnvoll. Die vorangehend genannten Fehlersimulationszellen sind der internen Steuereinheit zugeordnet und werden beispielsweise mit Steuerleitungen verbunden, die in einem Anschluss münden, der mit einem entsprechenden Anschluss der externen Steuereinheit verbindbar ist. Die externe Steuereinheit könnte hingegen in Abhängigkeit der Komplexität des zu prüfenden Systems unterschiedlich ausgeführt sein. Zum einen könnte die externe Steuereinheit beispielsweise einzelne Taster, Schalter oder dergleichen aufweisen, die mit den Steuerleitungen verbindbar sind. Ein Benutzer könnte dann selektiv durch Betätigen von Schaltern oder Tastern einzelne Fehlersimulationszellen gezielt ansteuern und damit entsprechende Fehler simulieren. Zum anderen könnte insbesondere bei komplexeren Systemen die externe Steuereinheit eine Prozessoreinheit, eine Recheneinheit oder ähnliches aufweisen, die dazu ausgebildet ist, ein bestimmtes Prüfprogramm automatisch auszuführen.

Nach einem vorgegebenen Schema, das etwa von einer Zulassungsvorschrift des Systems vorgegeben sein könnte, würden entsprechende Steuerbefehle ausgesandt werden, die zu der internen Steuereinheit gelangen. Dort können in Abhängigkeit der Steuerbefehle die einzelnen Fehlersimulationszellen angesteuert werden. Der besondere Vorteil der Unterteilung liegt darin, dass das System ohne die externe Steuereinheit nicht in der Lage ist, die Schalteinheiten zu betätigen. Unbetätigte Fehlersimulationszellen befinden sich dabei in dem normalen Betriebszustand und das System kann ohne die externe Steuereinheit ausschließlich herkömmlich betrieben werden. Die externe Steuereinheit kann von der Verifikationssteuereinheit angesteuert werden, darin integriert sein oder durch diese realisiert sein.

Bevorzugt weist die mindestens eine Fehlersimulationszelle einen elektronischen Schalter auf. Elektronische Schalter sind, im Gegensatz zu elektromechanischen Schaltern, lediglich elektronisch realisiert und weisen daher auch nicht die Nachteile von elektromechanischen Schaltern auf. Die elektronischen Schalter können beispielsweise mit Transistor-, Dioden-, Thyristor- und anderen Halbleiterschaltungen realisiert werden. Das System könnte, insbesondere bei einer Realisierung als Digitalschaltung, vollständig in den integrierten Schaltkreis eingebettet sein, um eine verbesserte Selbstprüffunktion durch das grundsätzliche Ermöglichen einer Verifikation der Selbstprüffunktion zu erlauben. Bei der Konzeption bzw. Auslegung des Systems können die Fehlersimulationszellen folglich unmittelbar berücksichtigt werden, sodass eine nachträgliche Modifikation eines neu entwickelten Systems zum Realisieren der Selbstprüfverifikation überhaupt nicht mehr notwendig ist. Damit können bei sinnvoller Auslegung und Konzeption eines insbesondere elektronischen Systems deutlich an Kosten und Aufwand eingespart und die Verifikation der Selbstprüffunktion ermöglicht werden.

Weiter vorteilhaft kann das System ferner mindestens eine Isoliereinheit zum bedarfsweisen elektrischen Isolieren einer der mindestens einen zu prüfenden Systemkomponente von anderen Systemkomponenten aufweisen. Um ein unerwartetes Verhalten von verschiedenen Systemkomponenten zu verhindern, kann es sich anbieten, während der Untersuchung einzelner Systemkomponenten diese von anderen Systemkomponenten elektrisch zu isolieren. Die Selbstprüfeinheit könnte beispielsweise bei Ablauf eines bestimmten Prüfschemas Eigenschaften der betreffenden Systemkomponente prüfen, während die anderen Systemkomponenten hiervon isoliert werden. Sind die zu prüfenden Parameter der betreffenden Systemkomponente erfolgreich geprüft worden, kann die Isolierung aufgehoben werden. Die Systemkomponente wird dadurch in den normalen Betriebszustand versetzt. Dies könnte sukzessive für alle weiteren Systemkomponenten durchgeführt werden.

Bevorzugt weist das System ferner eine Stimulationseinheit auf, die mit der mindestens einen Systemkomponente verbindbar ist und dazu ausgebildet ist, Eingangsgrößen für die betreffende Systemkomponente zu simulieren. Die Stimulationseinheit ist dazu vorgesehen, insbesondere eine elektrisch isolierte Systemkomponente mit bestimmten Eingangsgrößen zu versehen. Interagiert die betreffende Systemkomponente während des normalen Betriebs etwa mit anderen Systemkomponenten und weist sie ein Verhalten auf, das von den Eingangsgrößen abhängt, kann eine Durchführung eines Selbstprüfprozesses nur dann erfolgen, wenn die betreffende Systemkomponente mit den richtigen Eingangsgrößen versorgt ist. Diese Eingangsgrößen können beliebiger Natur sein und hängen vollkommen von der Art des Systems ab. Neben Spannungen, Signalen, elektrischen Zuständen und dergleichen können selbstverständlich auch Daten vorgesehen sein. Die Stimulationseinheit wird folglich auf das System abgestimmt und durch die Fehlersimulationseinheit oder die Verifikationssteuereinheit angesteuert. Die betreffende Systemkomponente unterscheidet sich in ihrem Betrieb dann nicht mehr von dem operationellen Betrieb.

In einer besonders bevorzugten Ausführungsform weist das System ferner eine Monitoreinheit auf, die dazu ausgebildet ist, eine Reaktion des Systems aufzunehmen. Beispielsweise kann die Monitoreinheit dazu ausgebildet sein, eine Reaktion des Systems auf einen durch die Stimulationseinheit ausgeführten Stimulus aufzunehmen. Beispielsweise kann die Monitoreinheit auch dazu ausgebildet sein, eine Reaktion des Systems auf eine Fehlersimulation aufzunehmen. Bevorzugt ist die Monitoreinheit dazu ausgebildet, die Reaktion mit einer zu erwartenden Reaktion zu vergleichen und eine Meldung abzugeben, sobald die Reaktion von einer zu erwartenden Reaktion abweicht. Dadurch kann auch ein Fehler in der Stimulationseinheit oder in dem System selbst erkannt werden. Die Monitoreinheit kann separat realisiert sein oder in der Selbstprüfeinheit und/oder der Verifikationssteuereinheit integriert sein.

Gemäß der Erfindung wird ein Verfahren zum Überprüfen von Selbstprüffunktionen in einem System gemäß Anspruch 9 bereitgestellt.

Das Verfahren kann in einer vorteilhaften Ausführungsform ferner den Schritt des elektrischen Isolierens der betreffenden Systemkomponente zumindest während des Beeinflussens des Betriebs aufweisen.

Besonders bevorzugt weist das Verfahren ferner das Simulieren von Eingangsgrößen für die betreffende Systemkomponente mittels einer Stimulationseinheit auf, die mit der mindestens einen Systemkomponente verbindbar ist.

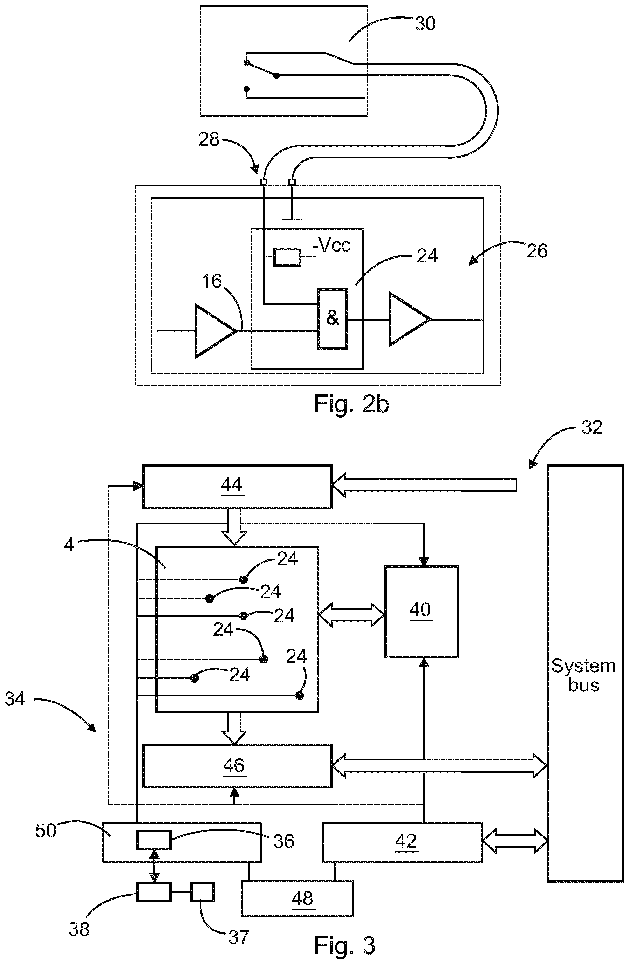

Gemäß einem dritten Aspekt der Erfindung wird ferner ein Luftfahrzeug mit mindestens einem vorangehend genannten System bereitgestellt. Insbesondere kann das System ein elektronisches System sein. Eine mögliche hierarchische Gliederung der Hardware in einem Luftfahrzeug kann a) das System selbst, hier also das Luftfahrzeug, b) ein Subsystem, etwa eine Avionik, c) ein "LRI", d) ein "SRI" und e) eine Elektronikkomponente, z.B. einen integrierten Schaltkreis, umfassen. Oftmals sind in einem Luftfahrzeug elektronische Geräte wie Navigationscomputer oder Transponder in Gehäusen untergebracht und können im Falle eines Defekts direkt ausgetauscht werden können und daher "Line Replaceable Items" (LRI) genannt werden. Ein solches LRI kann aus einzelnen Modulen bestehen, die "Shop Replaceable Items" (SRI) genannt werden, da defekte Module nur in der Werkstatt gewechselt werden können oder sollten. In der Regel könnte ein SRI eine Unterfunktionsgruppe des LRI sein. Die SRI kommunizieren in der Regel über einen Systembus miteinander, der weiter nachfolgend in Fig. 3 gezeigt ist. Die kann auf alle Ebenen angewandt werden.

### KURZE BESCHREIBUNG DER FIGUREN

Weitere Merkmale, Vorteile und Anwendungsmöglichkeiten der vorliegenden Erfindung ergeben sich aus der nachfolgenden Beschreibung der Ausführungsbeispiele und den Figuren. Dabei bilden alle beschriebenen und/oder bildlich dargestellten Merkmale für sich und in beliebiger Kombination den Gegenstand der Erfindung auch unabhängig von ihrer Zusammensetzung in den einzelnen Ansprüchen oder deren Rückbezügen. In den Figuren stehen weiterhin gleiche Bezugszeichen für gleiche oder ähnliche Objekte.
Fig. 1 zeigt eine schematische, blockbasierte Darstellung eines erfindungsgemäßen Systems.
Fig. 2a und 2b zeigen ein Prinzip einer Fehlersimulation nach dem Stand der Technik (Fig. 2a) und erfindungsgemäß (Fig. 2b).
Fig. 3 zeigt ein weiteres System in einer schematischen Darstellung.
Fig. 4a bis 4b zeigen zwei Beispiele für die Beeinflussung einer technischen Funktion einer Systemkomponente.
Fig. 5a bis 5d zeigen mehrere Beispiele für die Ansteuerung einer Fehlersimulationseinheit.
Fig. 6a bis 6c zeigen weitere Beispiele für die Fehlersimulation in einem System.
Fig. 7 zeigt ein Luftfahrzeug.

### DETAILLIERTE DARSTELLUNG EXEMPLARISCHER AUSFÜHRUNGSFORMEN

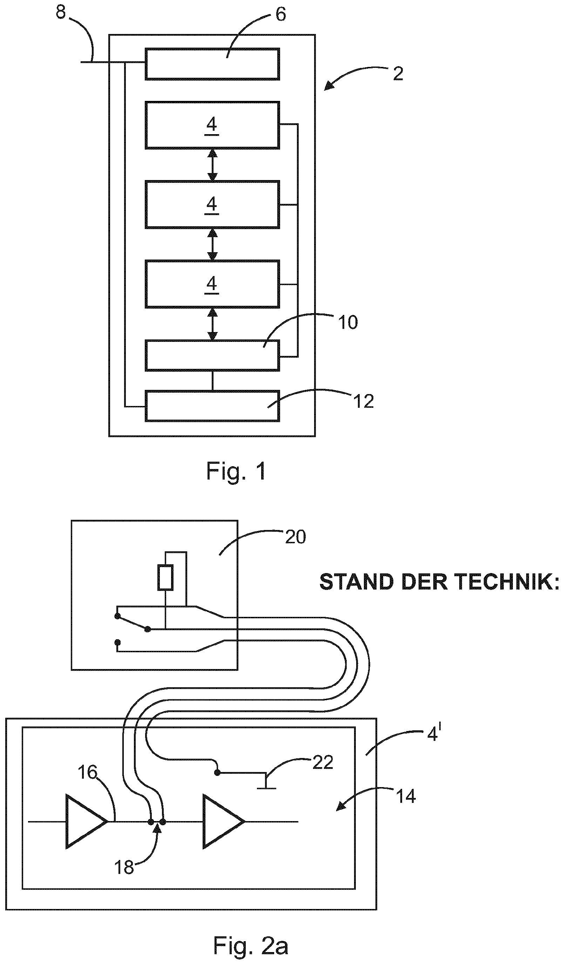

Fig. 1 zeigt sehr schematisch ein System 2 mit einer Selbstprüffunktion. Es sei darauf hingewiesen, dass diese Darstellung lediglich dem Verständnis des allgemeinen Aufbaus des erfindungsgemäßen Systems 2 dienen soll und daher nicht sehr detailliert ist. Verschiedene Details des Systems werden in den weiter nachfolgenden Figuren dargestellt.

Das System 2 weist eine Reihe von Systemkomponenten 4 auf, die jeweils mindestens eine technische Funktion ausführen können. Exemplarisch sind die Systemkomponenten 4 funktionell miteinander gekoppelt, sodass sie zur Realisierung des Systems 2 miteinander interagieren können. Zusätzlich dazu weist das System 2 eine Selbstprüfeinheit 6 auf, die mit den Systemkomponenten 4 verbunden ist. Diese Verbindung kann beispielsweise eine elektrische Verbindung mit signal- und/oder spannungsführenden Leitungen der Systemkomponenten 4 umfassen. Die Selbstprüfeinheit 6 soll hierdurch befähigt sein, bestimmte technische Funktionen der Systemkomponenten 4 zu überwachen bzw. zu prüfen, um dadurch eine Einschätzung darüber zu erhalten, ob entsprechende Systemparameter in einem zu erwartenden Bereich liegen. Die Selbstprüfeinheit 6 kann hieraus beispielsweise ein Warnsignal an einem ersten Ausgang 8 bereitstellen, das einen Hinweis darüber gibt, ob ein bestimmter Betriebsparameter von einem erwarteten Verhalten abweicht.

Zur Verifikation der Selbstprüfeinheit 6 ist zusätzlich eine Fehlersimulationseinheit 10 sowie eine Verifikationssteuereinheit 12 vorgesehen. Die Fehlersimulationseinheit 10 ist mit den einzelnen Systemkomponenten 4 gekoppelt und dazu ausgebildet, den Betrieb der Systemkomponenten 4 dahingehend zu beeinflussen, dass die jeweilige, mindestens eine technische Funktion selektiv beeinträchtigt ist. Wie weiter nachfolgend ausgeführt, kann das Beeinträchtigen durch unterschiedliche Maßnahmen erfolgen.

Die Fehlersimulationseinheit 10 wird durch die Verifikationssteuereinheit 12 angesteuert. Weiterhin ist die Verifikationssteuereinheit 12 dazu ausgebildet, die von der Selbstprüfeinheit 6 generierten Warnsignale mit zu erwartenden Warnsignalen, welche etwa von der jeweils beeinträchtigten technischen Funktion abhängen, zu vergleichen. Hierfür kann die Verifikationssteuereinheit 12 eine Kenntnis über ein Prüfschema besitzen, welches ein Prüfmuster mit mehreren zu durchlaufenden Schritten zum Beeinträchtigen von bestimmten Funktionen der Systemkomponenten 4 umfassen kann. Die Verifikationssteuereinheit 12 könnte weiterhin auch in der Lage sein, die Fehlersimulationseinheit 10 zum Durchführen eines Prüfschemas anzusteuern. Folglich können verschiedene Fehler nacheinander simuliert werden, um anschließend die in Reaktion auf die simulierten Fehler ausgegebenen Warnsignale der Selbstprüfeinheit 6 zu empfangen und mit den zu erwartenden Warnsignalen zu vergleichen. Fehlt etwa bei einem bestimmten simulierten Fehler ein Warnsignal oder ist ein mit dem simulierten Fehler korrespondierendes Warnsignals mit unerwarteten Informationen versehen, kann ein diesbezüglicher Defekt der Selbstprüfeinheit 6 angenommen werden. Das System 2 ist demnach in der Lage, einen Selbsttest zuverlässig auszuführen und bei Bedarf auch die Selbstprüffunktion zuverlässig zu überprüfen.

In Fig. 2a und 2b wird verdeutlicht, wie eine technische Funktion einer Systemkomponente beeinträchtigt werden kann. Fig. 2a zeigt den Stand der Technik. Hier wird eine herkömmliche Systemkomponente 4' gezeigt, die einen einfachen Schaltkreis 14 mit einer Leitung 16 aufweist. Zum Prüfen einer Selbstprüffunktion wird manuell eine Leitung in einem Schnittbereich 18 unterbrochen und beispielsweise durch Auflöten mit einem Schalter 20 verbunden. Hier wird beispielhaft die Leitung 16 mit einer Masseleitung 22 verbunden oder sie wird geschlossen, d.h. durch den Schalter 20 überbrückt. Der Schalter 20 befindet sich hierbei meist außerhalb der Systemkomponente 4' bzw. des übergeordneten Systems, um für den Bediener leicht zugänglich zu sein. Weiterhin kann erreicht werden, dass ein Gehäuse des Systems während des Betriebs geschlossen ist, um den realen Anwendungsfall möglichst gut wiederzugeben. Die Selbstprüffunktion kann eine Fehlfunktion der Systemkomponente 4' detektieren und ein entsprechendes Signal ausgeben. Eine solche Vorgehensweise ist für einfache Systemkomponenten 4' unter Umständen denkbar, doch insbesondere bei komplexen Schaltkreisen und mehreren Lagen einer Schaltplatine ist ein solches manuelles Auftrennen einer Leitung 16 nicht möglich. Eine durch den Schalter 20 bedingte veränderte Leitungsführung kann bei hochfrequenten Signalen, wie sie etwa bei modernen elektronischen Schaltungen vorzufinden sind, zu einer Beeinträchtigung des Signalübertragungsverhaltens bezüglich Laufzeit und Frequenzgang führen, sowie evtl. zu erhöhtem Übersprechen (Cross Talk) bezüglich benachbarter Signale. Eine solche Simulationsschaltung ist zu Verifikationszwecken nur akzeptabel unter der nachzuweisenden Annahme, dass die Beeinträchtigung der Signalübertragung durch den Schalter innerhalb der für die Übertagungsleitung spezifizierten Toleranzgrenzen liegen. Zudem kann dieses Vorgehen nur zur einmaligen Verifikation eines Selbsttests unter Laborbedingungen genutzt werden, sodass die Überprüfung des Selbsttests nach Inbetriebnahme des Systems 2 überhaupt nicht möglich wäre.

Wie in Fig. 2b gezeigt, weist eine Systemkomponente 4 des erfindungsgemäßen Systems 2 indes eine Fehlersimulationszelle 24 in Form einer elektronischen Schalteinheit auf, die einen integralen Bestandteil eines Schaltkreises 26 der Systemkomponente 4 bildet. Die Fehlersimulationszelle 24 ist elektronisch steuerbar und weist hierfür beispielsweise ein Anschlusspaar 28 auf, das vorteilhafterweise durch einen Testanschluss an einem Gehäuse realisiert werden kann. An das Anschlusspaar 28 kann ein Schalter 30 angeschlossen werden. Durch Betätigen des Schalters 30 öffnet die Fehlersimulationszelle 24 die entsprechende Leitung 16. Der besondere Vorteil der Schaltung liegt darin, dass die Signalübertragungseigenschaften von Leitung 16 wie Frequenzgang und Signallaufzeit und Übersprechen nicht mehr durch die den Schalter 30 mit Anschlusspaar 28 verbindenden Kabel bestimmt wird, sondern nur noch durch die Fehlersimulationszelle 24. Die Fehlersimulationszelle 24 wird idealerweise im Bereich der Leitung 16 angebracht, sodass die Leitungsführung von Leitung 16 nicht signifikant für die Simulationseinheit modifiziert werden muss und damit auch die Signalübertragungseigenschaften nicht wesentlich verändert werden. Die Fehlersimulationszelle 24 ist ein integraler Bestandteil des Systems und somit werden die Signalübertragungseigenschaften der Fehlersimulationszelle 24 beim Systementwurf berücksichtigt, sodass diese die Systemfunktion nicht beeinträchtigen. Eine solche Fehlerstimulationszelle kann als Standard-Fehlersimulationszelle in einem System 2 an mehreren Stellen eingesetzt werden.

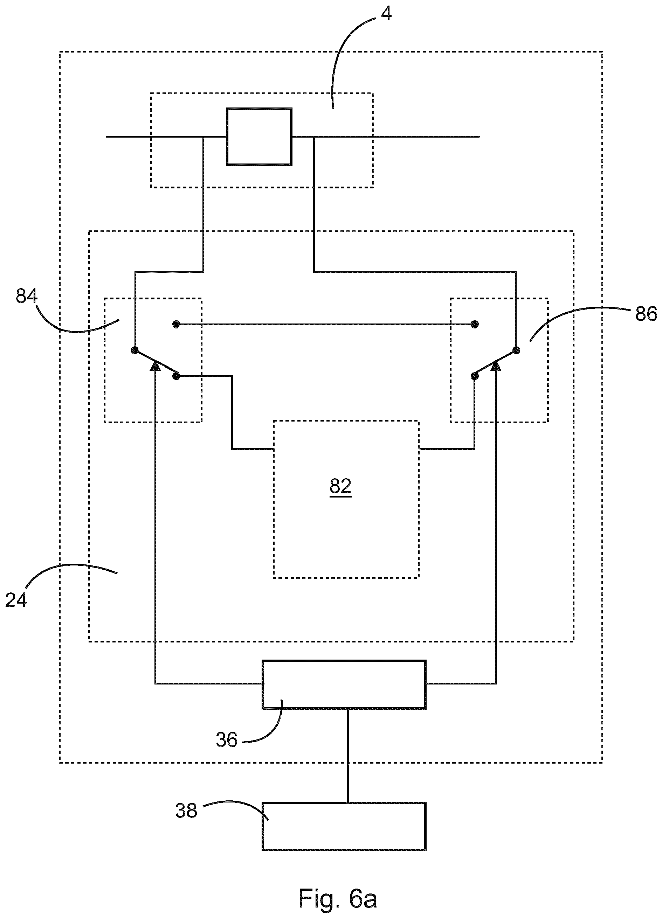

In Verallgemeinerung der Fehlersimulationszelle 24 kann eine Fehlersimulationszelle 24 definiert werden, die eine Fehleraktivierungseinheit und eine Modifikationseinheit aufweisen könnte, wie in Fig. 6a weiter erläutert. Die Fehleraktivierungseinheit kann typischerweise elektronische Schalter aufweisen, die die Modifikationseinheit zu- oder wegschalten kann, wobei die Modifikationseinheit die Art der Fehlersimulation bestimmt.

Ein weiterer, besonderer Vorteil liegt darin, dass die Fehlersimulationszelle 24 in dem gezeigten Beispiel als ein UND-Gatter ausgeführt ist, das ausschließlich bei einem aktivierten und angeschlossenen Schalter 30 die Verbindung trennt und dadurch einen Fehler simuliert. Ist der Schalter 30 nicht an dem Anschlusspaar 28 angeschlossen, wird die Verbindung stets aufrecht erhalten. Die Systemkomponente 4 wird dann auf herkömmliche Weise betrieben.

An dieser Stelle sei angemerkt, dass der Schaltkreis 26 ein integrierter Schaltkreis mit einer hohen 6, 7 oder 8-stelligen Anzahl von Transistoren sein kann und die Fehlersimulationszelle 24 lediglich als zusätzliches Logikgatter ausgeführt ist und folglich die Komplexität des Schaltkreises 26 praktisch nicht ändert. Zudem ist lediglich an wenigen, repräsentativen Stellen des Schaltkreises 26 eine solche Schalteinheit 24 notwendig.

Fig. 3 zeigt ein System 32, das dem System 2 entspricht, jedoch beispielhaft lediglich eine einzelne Systemkomponente 4 aufweist. Diese kann beispielsweise eine Platine oder ein recht komplexer, integrierter Schaltkreis, wie beispielsweise ein Embedded Prozessor, sein. Eine Verifikationssteuereinheit 50 ist mit mehreren Fehlersimulationszellen 24 verbunden, welche analog zu Fig. 2b in der Systemkomponente 4 angeordnet sind. Hierzu ist die Verifikationssteuereinheit 50 mit einer Fehlersimulationseinheit 34 gekoppelt, wobei die Schalter 30 der Fehlersimulationseinheit 34 zugeordnet bzw. durch sie realisiert sind.

Die Fehlersimulationseinheit 34 könnte neben einer Vielzahl von Fehlersimulationszellen 24 ein einzelnes Steuergerät aufweisen oder eine interne Steuereinheit 36 und eine externe Steuereinheit 38. Insbesondere bei der Verwendung sehr vieler Fehlersimulationszellen 24 bietet es sich an, beispielsweise eine Initiierung eines Verifikationsvorgangs der Selbstprüffunktion von der externen Steuereinheit 38 auszuführen, wobei die externe Steuereinheit 38 kontinuierlich Informationen an die interne Steuereinheit 36 sendet, welche der Fehlersimulationszellen 24 jeweils anzusteuern sind. Um Beeinträchtigungen anderer Systemkomponenten zu verhindern, weist das System 32 zusätzlich eine Isoliereinheit 40 auf. Diese kann bedarfsweise die zu prüfenden Systemkomponente 4 elektrisch von anderen Systemkomponenten 4 isolieren.

Eine Selbstüberprüfung kann sowohl eine Selbstüberwachung als auch eine Selbstprüfung umfassen. In beiden Fällen kann das System durch eine Monitorfunktion 42 überwacht werden, wobei beim Selbsttest das System zusätzlich einem Stimulus durch eine Stimulationseinheit 44 ausgesetzt wird.

Zum Durchführen der Selbstprüfung ist eine Selbstprüfeinheit 42 vorgesehen, die mit der Systemkomponente 4, der Isolationseinheit 40, der Stimulationseinheit 44 und einer Monitoreinheit 46 gekoppelt ist. Die Stimulationseinheit 44 ist dazu vorgesehen, verschiedene Signale an die Systemkomponente 4 zu übertragen, sodass die erforderlichen Eingangsgrößen vorliegen und in der Systemkomponente 4 ein bestimmtes Verhalten auslösbar ist, welches von der Monitoreinheit 46 detektiert werden kann Dies ist besonders dann sinnvoll, wenn die Isoliereinheit 40 die Systemkomponente 4 vollständig von den üblicherweise im normalen Betrieb vorhandenen Interaktionspartnern trennt. Durch Stimulation mithilfe von Testsignalen kann folglich die Selbstprüfeinheit42 das Verhalten der Systemkomponente 4 unter realen Bedingungen prüfen und eine Fehlermeldung ausgeben, wenn das Verhalten der Systemkomponente 4 nicht dem erwarteten Verhalten entspricht. Die Fehlermeldung kann über einen Systembus weitergeben werden. Die Fehlermeldung kann auch versehen mit einem Zeitstempel in einem nichtflüchtigen Speicher 48 abgelegt werden. Der Speicherinhalt kann über eine an einem Teststecker 37 verfügbare serielle Schnittstelle abgefragt werden. Die Historie der Fehlermeldungen ist dann zu Wartungszwecken verfügbar.

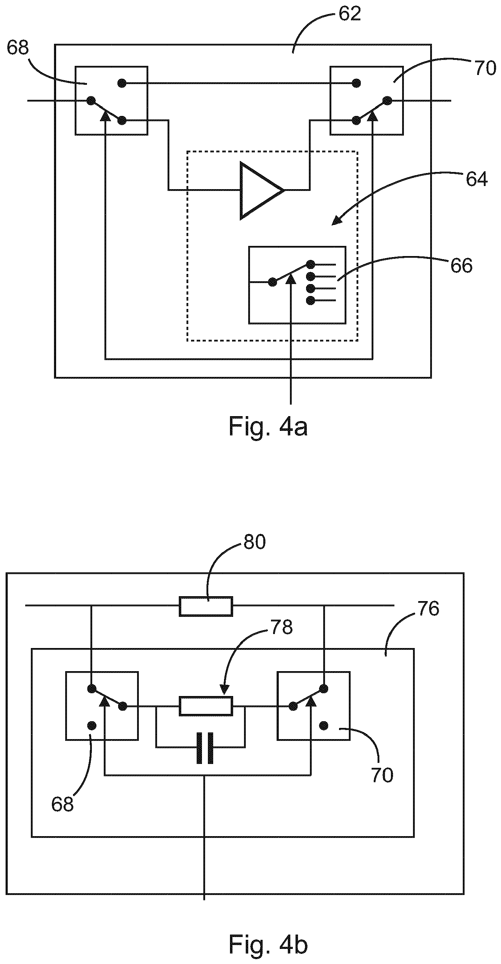

Bei der Beeinflussung von Systemkomponenten insbesondere in komplexen Schaltkreisen können verschiedene Varianten in Erwägung gezogen werden. Fig. 4a zeigt beispielhaft eine Fehlersimulationszelle 62 als eine Schalteinheit, die gleichzeitig mit einem Filtermodul 64 ausgestattet ist, das über ein Auswahlmodul 66 ansteuerbar ist. Zwei Schalter 68 und 70 können ein eingehendes Signal entweder zwischen einem Eingang 72 und einem Ausgang 74 durchschleifen oder durch das Filtermodul 64 leiten. Mit dem Filtermodul 64 kann ein Signal manipuliert werden, sodass Fehlfunktionen von Baugruppen gezielt simuliert werden können.

Fig. 4b zeigt exemplarisch eine Fehlersimulationszelle 76, die mit einem RC-Glied 78 ausgestattet ist, das über die beiden Schalter 68 und 70 mit einer Systemkomponente 80 parallel schaltbar ist. Durch Umlegen der Schalter 68 und 70 kann das RC-Glied 78 parallel geschaltet oder hiervon getrennt werden. Über geeignete Dimensionierung des RC Gliedes 78 können bestimmte Fehlerszenarien gezielt simuliert werden.

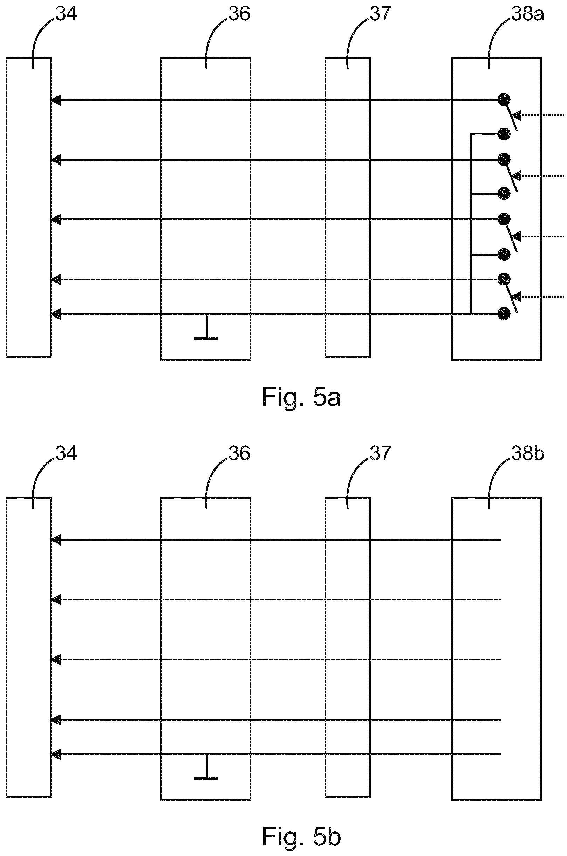

Fig. 5a zeigt eine Variante der externen Steuereinheit 38 in Form einer Schalterbox 38a mit mehreren extern bedienbaren Schaltern, welche über den Teststecker 37 mit der internen Steuereinheit 36 und dadurch mit der Fehlersimulationseinheit 34 verbindbar ist.

Fig. 5b zeigt einen äquivalenten Aufbau wie Fig. 5a, jedoch ist dort statt einer Schalterbox 38a ein externes Steuergerät 38b für diskrete Steuersignale vorgesehen. Dies kann den Verifikationsprozess automatisch durchführen.

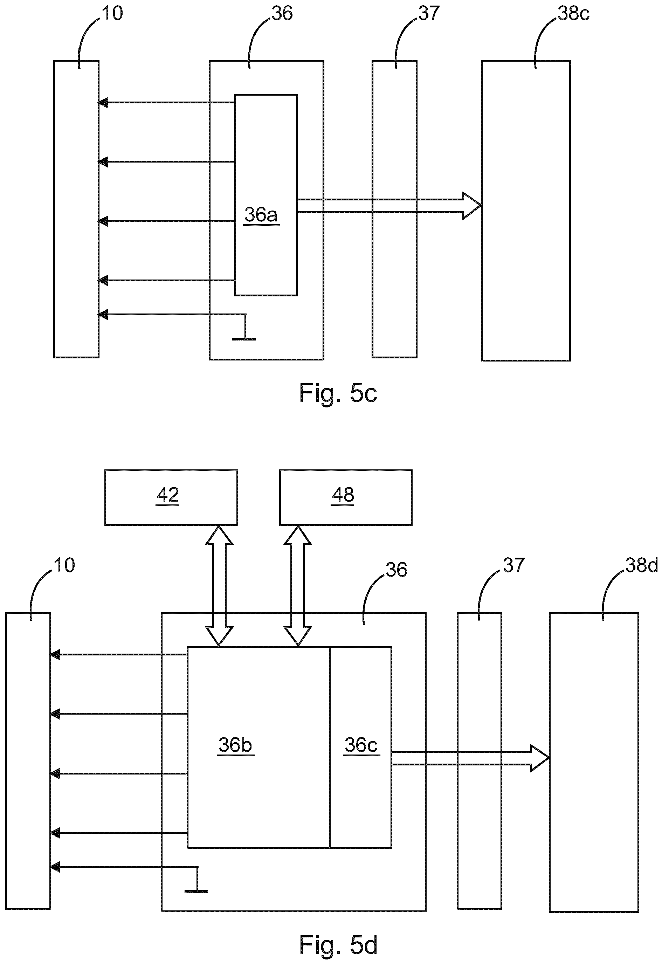

Fig. 5c zeigt einen Aufbau, der zu dem in Fig. 5b äquivalent ist. Einzelne Steuerleitungen werden jedoch nicht einzeln über den Teststecker 37 herausgeführt, sondern über eine serielle Schnittstelle 36a. Ein externes Steuergerät 38c aktiviert die einzelnen Fehlersimulationszellen 24 in der Fehlersimulationseinheit 10 über die serielle Schnittstelle 36a.

Fig. 5d zeigt eine an Fig. 5c angelehnte Variante, bei der ein externes Steuergerät 38d als ein Mikrokontroller 36b realisiert ist. Dieser ist über eine serielle Schnittstelle 36c über den Teststecker 37 mit der Außenwelt verbunden. Der Mikrokontroller 36b kommuniziert mit der Selbstprüfsteuereinheit 42 und speichert die Verifikationsergebnisse im Speicher 48 ab.

Fig. 6a zeigt eine Grundstruktur einer Fehlersimulationszelle 24. Hier kann eine zu beeinflussende Systemkomponente 4 über eine Modifikationseinheit 82, die über Schalter 84 und 86 mit der Systemkomponente 4 verbindbar ist, bedarfsweise aktiv beeinflusst werden. Die Schalter 84 und 86, durch die die Fehlersimulation aktivierbar ist, können daher als Fehleraktivierungseinheit bezeichnet werden. Diese können durch können die interne Steuereinheit 36 angesteuert werden, welche mit der externen Steuereinheit 38 in Signalverbindung steht.

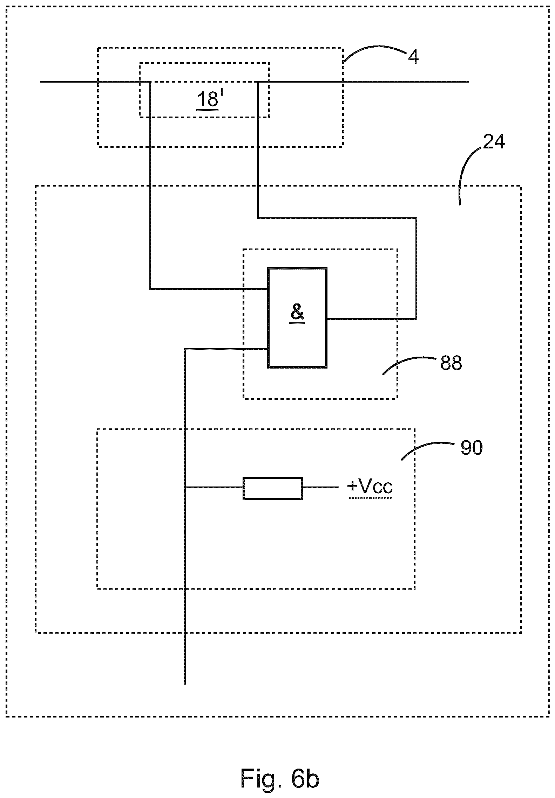

Fig. 6b zeigt die Fehlersimulationszelle 24 zur Simulation der Unterbrechung einer Leitung, die hier als eine zu beeinflussende Systemkomponente 4 gezeigt ist. Diese weist einen Trennpunkt 92 auf, die mit einer Fehleraktivierungseinheit 88 und einer Modifikationseinheit 90 verknüpft ist. Statt der Verwendung von zwei Schaltern 84 und 86 weist die Fehleraktivierungseinheit 88 ein UND-Gatter auf, welches bereits etwa in Fig. 2b gezeigt wird.

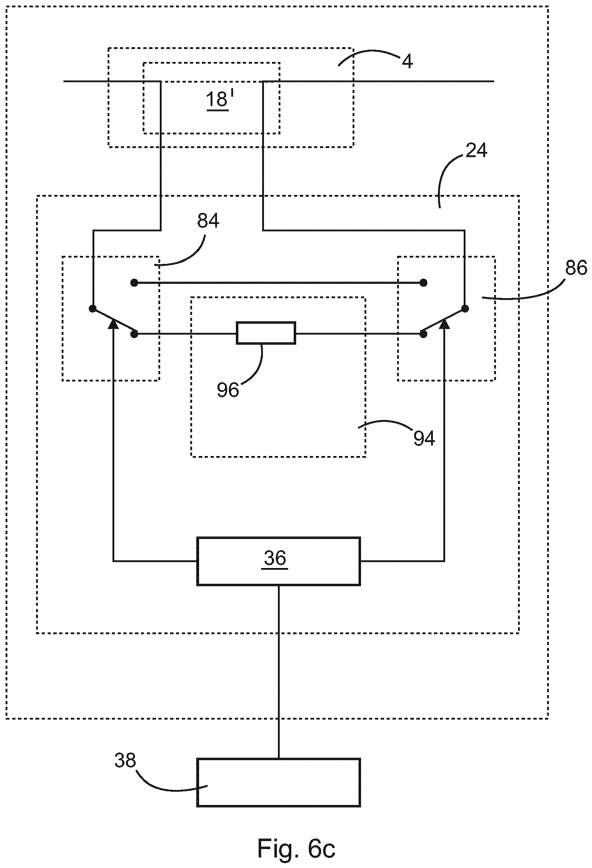

Fig. 6c zeigt die Realisierung eines erhöhten Leitungswiderstands als Abwandlung der Darstellung aus Fig. 6b. Eine Modifikationseinheit 94 weist einen Widerstand 96 auf, der über die Schalter 84 und 86 bedarfsweise den Trennpunkt 92 überbrückt.

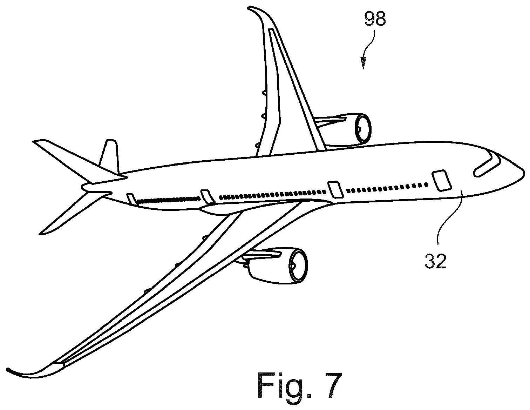

Schließlich zeigt Fig. 7 ein Luftfahrzeug 98, welches beispielhaft mit einem erfindungsgemäßen System 32 ausgestattet ist, das einen Teil der Avionik ausbildet.

Ergänzend sei darauf hingewiesen, dass "aufweisend" keine anderen Elemente oder Schritte ausschließt, und "ein" oder "eine" keine Vielzahl ausschließt. Ferner sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können. Bezugszeichen in den Ansprüchen sind nicht als Einschränkung anzusehen.

### BEZUGSZEICHEN

- 2: System
- 4: Systemkomponente
- 4': herkömmliche Systemkomponente
- 6: Selbstprüfeinheit
- 8: erster Ausgang
- 10: Fehlersimulationseinheit
- 12: Verifikationssteuereinheit
- 14: Schaltkreis
- 16: Leitung
- 18: Schnittbereich
- 20: Schalter
- 22: Masseleitung
- 24: Fehlersimulationszelle
- 26: Schaltkreis
- 28: Anschlusspaar
- 30: Schalter
- 32: System
- 34: Fehlersimulationseinheit
- 36: interne Steuereinheit
- 36a: Steuereinheit mit serieller Schnittstelle
- 36b: Mikrocontroller
- 36c: Serielle Schnittstelle für Mikrocontroller
- 37: Teststecker
- 38: externe Steuereinheit
- 38a: Schalterbox
- 38b: Externes Steuergerät für diskrete Steuersignale
- 38c: Externes Steuergerät mit serieller Schnittstelle
- 38d: externes Steuergerät
- 40: Isoliereinheit
- 42: Selbstprüfeinheit
- 44: Stimulationseinheit
- 46: Monitoreinheit
- 48: Speicher
- 50: Verifikationssteuereinheit
- 62: Fehlersimulationszelle
- 64: Filtermodul
- 66: Auswahlmodul
- 68: Schalter
- 70: Schalter
- 72: Eingang
- 74: Ausgang
- 76: Fehlersimulationszelle
- 78: RC-Glied
- 80: Systemkomponente
- 82: Modifikationseinheit
- 84: Schalter
- 86: Schalter
- 88: Fehleraktivierungseinheit
- 90: Modifikationseinheit
- 92: Trennpunkt
- 94: Modifikationseinheit
- 96: Widerstand
- 98: Luftfahrzeug

## Patentansprüche

1. System (2, 32) mit Selbstprüffunktion, aufweisend:
mindestens eine elektrische oder elektronische Systemkomponente (4), die mindestens eine technische Funktion besitzt,
eine in dem System (2, 32) integrierte Fehlersimulationseinheit (10),
eine in dem System (2, 32) integrierte Selbstprüfeinheit (6), und
eine in dem System (2, 32) integrierte Verifikationssteuereinheit (12),
wobei die mindestens eine Systemkomponente (4) mit der Fehlersimulationseinheit (10) gekoppelt ist,
wobei die Fehlersimulationseinheit (10) dazu ausgebildet ist, den Betrieb der Systemkomponente (4) dahingehend zu beeinflussen, dass die mindestens eine technische Funktion selektiv beeinträchtigt ist,
wobei die Fehlersimulationseinheit (10) mindestens eine elektronisch ansteuerbare Fehlersimulationszelle (24, 76) aufweist, die jeweils in der mindestens einen Systemkomponente (4) integriert ist und dazu ausgebildet ist, selektiv eine Leitung (16, 22) der betreffenden Systemkomponente (4) zu öffnen oder eine Verbindung der betreffenden Leitung (16, 22) mit einer anderen Leitung (16, 22) oder einer zusätzlichen Elektronikkomponente selektiv zu schließen,
wobei die Selbstprüfeinheit (6) dazu ausgebildet ist, Betriebsparameter der Systemkomponente (4) zu überwachen und jeweils ein Warnsignal zu generieren, das eine Beeinträchtigung der jeweiligen mindestens einen technischen Funktion anzeigt, und
wobei die Verifikationssteuereinheit (12) dazu ausgebildet ist, die von der Selbstprüfeinheit (6) generierten Warnsignale mit zu erwartenden Warnsignalen in Abhängigkeit der jeweiligen mindestens einen beeinträchtigten technischen Funktion zu vergleichen, wobei die Selbstprüfeinheit (6) dazu ausgebildet ist, einen Wartungshinweis auszugeben, wenn das jeweils generierte Warnsignal nicht mit einem erwartenden Warnsignal übereinstimmt.

2. System (2, 32) nach Anspruch 1,
wobei die mindestens eine Systemkomponente (4) eine Digitalelektronik aufweist.

3. System (2, 32) nach Anspruch 1 oder 2,
wobei die andere Leitung (16, 22) eine Masseverbindung oder eine Verbindung zum Logiklevel "1" aufweist.

4. System (2, 32) nach einem der vorhergehenden Ansprüche,
wobei die zusätzliche Elektronikkomponente aus einer Gruppe von Elektronikkomponenten ausgewählt ist, die Gruppe aufweisend:
- einen Widerstand,
- eine Kapazität,
- eine Induktivität,
- analoge Filter,
- digitale Filter,
- Logikbausteine,
- Überbrückungsleitungen, und
- Spannungsquellen.

5. System (2, 32) nach einem der vorhergehenden Ansprüche,
wobei die Fehlersimulationseinheit (10) eine externe Steuereinheit (38) und eine mit der externen Steuereinheit (38) verbindbare interne Steuereinheit (36) aufweist,
wobei die mindestens eine Fehlersimulationszelle (24, 76) in der internen Steuereinheit (36) angeordnet und von der externen Steuereinheit (38) steuerbar ist, und
wobei die mindestens eine Fehlersimulationszelle (24, 76) und/oder die interne Steuereinheit (36) dazu ausgebildet sind, dass die mindestens eine Fehlersimulationszelle (24, 76) ohne Verbindung mit der externen Steuereinheit (38) nicht geschaltet ist.

6. System (2, 32) nach einem der vorhergehenden Ansprüche,
wobei die mindestens eine Fehlersimulationszelle (24, 76) einen elektronischen Schalter aufweist.

7. System (2, 32) nach einem der vorhergehenden Ansprüche,
ferner aufweisend mindestens eine Isoliereinheit (40) zum bedarfsweisen elektrischen Isolieren einer der mindestens einen Systemkomponente (4) von anderen Systemkomponenten (4).

8. System (2, 32) nach einem der vorhergehenden Ansprüche,
ferner aufweisend eine Stimulationseinheit (44), die mit der mindestens einen Systemkomponente (4) verbindbar ist und dazu ausgebildet ist, Eingangsgrößen für die betreffende Systemkomponente (4) zu simulieren.

9. Verfahren zum Überprüfen von Selbstprüffunktionen in einem System (2, 32), aufweisend die Schritte:
- Beeinflussen des Betriebs mindestens einer elektrischen oder elektronischen Systemkomponente (4), die mindestens eine technische Funktion besitzt, durch eine in dem System (2, 32) integrierte Fehlersimulationseinheit (10), sodass die mindestens eine technische Funktion selektiv beeinträchtigt ist,
- wobei das Beeinflussen des Betriebs das selektive Öffnen einer Leitung (16, 22) der betreffenden Systemkomponente (4) oder das selektive Schließen einer Verbindung der betreffenden Leitung (16, 22) mit einer anderen Leitung (16, 22) oder einer zusätzlichen Elektronikkomponente umfasst
- Überwachen von Betriebsparametern der Systemkomponente (4) durch eine in dem System (2, 32) integrierte Selbstprüfeinheit (6) und Generieren eines Warnsignals, das eine Beeinträchtigung der jeweiligen mindestens einen technischen Funktion anzeigt,
- Vergleichen des generierten Warnsignals mit zu erwartenden Warnsignalen in Abhängigkeit der jeweiligen mindestens einen beeinträchtigten technischen Funktionen durch eine Verifikationssteuereinheit (12), und
- Ausgeben eines Wartungshinweises, wenn das generierte Warnsignal nicht mit einem erwarteten Warnsignal übereinstimmt.

10. Verfahren nach Anspruch 9,
ferner aufweisend den Schritt des elektrischen Isolierens der betreffenden Systemkomponente (4) zumindest während des Beeinflussens des Betriebs.

11. Verfahren nach einem der Ansprüche 9 bis 10,
ferner aufweisend das Simulieren von Eingangsgrößen für die betreffende Systemkomponente (4) mittels einer Stimulationseinheit (44), die mit der mindestens einen Systemkomponente (4) verbindbar ist.

12. Luftfahrzeug mit mindestens einem System (2) nach einem der Ansprüche 1 bis 8.

## Claims

1. System (2, 32) with a self-test function, comprising:
at least one electrical or electronic system component (4) having at least one technical function,
a fault simulation unit (10) integrated in the system (2, 32),
a self-test unit (6) integrated in the system (2, 32), and
a verification control unit (12) integrated in the system (2, 32),
wherein the at least one system component (4) is coupled to the fault simulation unit (10),
wherein the fault simulation unit (10) is designed to influence the operation of the system component (4) in such a way that the at least one technical function is selectively impaired,
wherein the fault simulation unit (10) has at least one electronically controllable fault simulation cell (24, 76) which is integrated in each case in the at least one system component (4) and is designed to selectively open a line (16, 22) of the relevant system component (4) or to selectively close a connection of the relevant line (16, 22) to another line (16, 22) or an additional electronic component,
wherein the self-test unit (6) is designed to monitor operating parameters of the system component (4) and to respectively generate a warning signal indicating an impairment of the respective at least one technical function, and
wherein the verification control unit (12) is designed to compare the warning signals generated by the self-test unit (6) with expected warning signals on the basis of the respective at least one impaired technical function,
wherein the self-test unit (6) is designed to output a maintenance instruction if the respectively generated warning signal does not correspond to an expected warning signal.

2. System (2, 32) according to Claim 1,
wherein the at least one system component (4) has digital electronics.

3. System (2, 32) according to Claim 1 or 2,
wherein the other line (16, 22) has an earth connection or a connection to logic level "1".

4. System (2, 32) according to one of the preceding claims,
wherein the additional electronic component is selected from a group of electronic components, the group comprising:
- a resistance,
- a capacitance,
- an inductance,
- analogue filters,
- digital filters,
- logic modules,
- bridging lines, and
- voltage sources.

5. System (2, 32) according to one of the preceding claims,
wherein the fault simulation unit (10) has an external control unit (38) and an internal control unit (36) which can be connected to the external control unit (38),
wherein the at least one fault simulation cell (24, 76) is arranged in the internal control unit (36) and can be controlled by the external control unit (38), and
wherein the at least one fault simulation cell (24, 76) and/or the internal control unit (36) is/are designed to ensure that the at least one fault simulation cell (24, 76) is not connected without a connection to the external control unit (38).

6. System (2, 32) according to one of the preceding claims,
wherein the at least one fault simulation cell (24, 76) has an electronic switch.

7. System (2, 32) according to one of the preceding claims,
further comprising at least one isolation unit (40) for electrically isolating one of the at least one system component (4) from other system components (4) as required.

8. System (2, 32) according to one of the preceding claims,
further comprising a stimulation unit (44) which can be connected to the at least one system component (4) and is designed to simulate input variables for the relevant system component (4).

9. Method for checking self-test functions in a system (2, 32), comprising the steps of:
- influencing the operation of at least one electrical or electronic system component (4), which has at least one technical function, by means of a fault simulation unit (10) integrated in the system (2, 32), such that the at least one technical function is selectively impaired,
- wherein influencing the operation comprises selectively opening a line (16, 22) of the relevant system component (4) or selectively closing a connection of the relevant line (16, 22) to another line (16, 22) or an additional electronic component,
- monitoring operating parameters of the system component (4) by means of a self-test unit (6) integrated in the system (2, 32) and generating a warning signal indicating an impairment of the respective at least one technical function,
- comparing the generated warning signal with expected warning signals on the basis of the respective at least one impaired technical function by means of a verification control unit (12), and
- outputting a maintenance instruction if the generated warning signal does not match an expected warning signal.

10. Method according to Claim 9,
further comprising the step of electrically isolating the relevant system component (4) at least while influencing the operation.

11. Method according to one of Claims 9 to 10,
further comprising simulating input variables for the relevant system component (4) by means of a stimulation unit (44) which can be connected to the at least one system component (4).

12. Aircraft having at least one system (2) according to one of Claims 1 to 8.

## Revendications

1. Système (2, 32) avec fonction d'autocontrôle, comprenant :
au moins un composant de système (4) électrique ou électronique qui possède au moins une fonction technique,
une unité de simulation d'erreur (10) intégrée dans le système (2, 32),
une unité d'autocontrôle (6) intégrée dans le système (2, 32), et
une unité de commande de vérification (12) intégrée dans le système (2, 32),
l'au moins un composant de système (4) étant couplé à l'unité de simulation d'erreur (10),
l'unité de simulation d'erreur (10) étant configurée pour influencer le fonctionnement du composant de système (4) de telle sorte que l'au moins une fonction technique soit altérée de manière sélective,
l'unité de simulation d'erreur (10) possédant au moins une cellule de simulation d'erreur (24, 76) pouvant être commandée électroniquement, qui est intégrée respectivement dans l'au moins un composant de système (4) et qui est configurée pour ouvrir sélectivement une ligne (16, 22) du composant de système (4) concerné ou pour fermer sélectivement une connexion de la ligne (16, 22) concernée avec une autre ligne (16, 22) ou un composant électronique supplémentaire,
l'unité d'autocontrôle (6) étant configurée pour surveiller des paramètres de fonctionnement du composant de système (4) et pour générer respectivement un signal d'avertissement qui indique une altération de l'au moins une fonction technique respective, et
l'unité de commande de vérification (12) étant configurée pour comparer les signaux d'avertissement générés par l'unité d'autocontrôle (6) avec des signaux d'avertissement attendus en fonction de l'au moins une fonction technique altérée respective, l'unité d'autocontrôle (6) étant configurée pour délivrer une notification de maintenance lorsque le signal d'avertissement respectivement généré ne coïncide pas avec un signal d'avertissement attendu.

2. Système (2, 32) selon la revendication 1,
l'au moins un composant de système (4) possédant une électronique numérique.

3. Système (2, 32) selon la revendication 1 ou 2,
l'autre ligne (16, 22) possédant une connexion à la masse ou une connexion au niveau logique « 1 ».

4. Système (2, 32) selon l'une des revendications précédentes,
le composant électronique supplémentaire étant choisi dans un groupe de composants électroniques, le groupe comprenant :
- une résistance,
- une capacité,
- une inductance,
- des filtres analogiques,
- des filtres numériques,
- des composants logiques,
- des lignes de pontage et
- des sources de tension.

5. Système (2, 32) selon l'une des revendications précédentes,
l'unité de simulation d'erreur (10) possédant une unité de commande externe (38) et une unité de commande interne (36) pouvant être connectée à l'unité de commande externe (38),
l'au moins une cellule de simulation d'erreur (24, 76) étant disposée dans l'unité de commande interne (36) et pouvant être commandée par l'unité de commande externe (38), et
l'au moins une cellule de simulation d'erreur (24, 76) et/ou l'unité de commande interne (36) étant configurées pour que l'au moins une cellule de simulation d'erreur (24, 76) ne soit pas commutée en l'absence de connexion avec l'unité de commande externe (38).

6. Système (2, 32) selon l'une des revendications précédentes,
l'au moins une cellule de simulation d'erreur (24, 76) possédant un commutateur électronique.

7. Système (2, 32) selon l'une des revendications précédentes,
possédant en outre au moins une unité d'isolation (40) destinée à isoler électriquement, selon le besoin, l'un de l'au moins un composant de système (4) d'autres composants de système (4).

8. Système (2, 32) selon l'une des revendications précédentes,
possédant en outre une unité de stimulation (44) qui peut être connectée à l'au moins un composant de système (4) et qui est configurée pour simuler des grandeurs d'entrée pour le composant de système (4) concerné.

9. Procédé de vérification des fonctions d'autocontrôle dans un système (2, 32), comprenant les étapes suivantes :
- influence du fonctionnement d'au moins un composant de système (4) électrique ou électronique qui possède au moins une fonction technique, par une unité de simulation d'erreur (10) intégrée dans le système (2, 32), de telle sorte que l'au moins une fonction technique soit altérée de manière sélective,
- l'influence du fonctionnement comprenant l'ouverture sélective d'une ligne (16, 22) du composant de système (4) concerné ou la fermeture sélective d'une connexion de la ligne (16, 22) concernée avec une autre ligne (16, 22) ou un composant électronique supplémentaire
- surveillance de paramètres de fonctionnement du composant de système (4) par une unité d'autocontrôle (6) intégrée dans le système (2, 32) et génération d'un signal d'avertissement qui indique une altération de l'au moins une fonction technique respective,
- comparaison du signal d'avertissement généré avec des signaux d'avertissement attendus en fonction de l'au moins une fonction technique respective altérée par une unité de commande de vérification (12), et
- délivrance d'une notification de maintenance lorsque le signal d'avertissement généré ne coïncide pas avec un signal d'avertissement attendu.

10. Procédé selon la revendication 9,
comprenant en outre l'étape d'isolation électrique du composant de système (4) concerné au moins pendant l'influence du fonctionnement.

11. Procédé selon l'une des revendications 9 à 10,
comprenant en outre la simulation de variables d'entrée pour le composant de système (4) concerné au moyen d'une unité de stimulation (44) qui peut être connectée à l'au moins un composant de système (4).

12. Aéronef comprenant au moins un système (2) selon l'une des revendications 1 à 8.
